(19) **Europäisches Patentamt**
**European Patent Office**
**Office européen des brevets**

(11) **EP 3 763 134 B1**

(12) **EUROPEAN PATENT SPECIFICATION**

(45) Date of publication and mention
of the grant of the patent:
**25.06.2025 Bulletin 2025/26**

(21) Application number: **19715554.2**

(22) Date of filing: **04.03.2019**

(51) International Patent Classification (IPC):
$H04R\ 3/04^{(2006.01)}$ $\qquad$ $H03G\ 5/00^{(2006.01)}$
$H03G\ 5/16^{(2006.01)}$ $\qquad$ $H03G\ 5/02^{(2006.01)}$
$H03H\ 17/02^{(2006.01)}$

(52) Cooperative Patent Classification (CPC):
**H04R 3/04; H03G 5/005; H03G 5/025; H03G 5/165;
H03H 17/0286**

(86) International application number:
**PCT/IB2019/051720**

(87) International publication number:
**WO 2019/171244 (12.09.2019 Gazette 2019/37)**

(54) **METHOD AND DEVICE FOR ADJUSTING THE FREQUENCY RESPONSE OF A DIGITAL FILTER**

VERFAHREN UND VORRICHTUNG ZUR EINSTELLUNG DES FREQUENZGANGES EINES
DIGITALEN FILTERS

PROCÉDÉ ET DISPOSITIF DE RÉGLAGE DE RÉPONSE FRÉQUENTIELLE DE FILTRE
NUMÉRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.03.2018 IT 201800003311**

(43) Date of publication of application:
**13.01.2021 Bulletin 2021/02**

(73) Proprietor: **Outline S.r.l.**
**25020 Flero (BS) (IT)**

(72) Inventors:
 • **NOSELLI, Michele**
 **25020 Flero, Brescia (IT)**
 • **NOSELLI, Stefano**
 **25020 Flero, Brescia (IT)**

 • **BIFFI, Giorgio**
 **25020 Flero, Brescia (IT)**

(74) Representative: **Chimini, Francesco**
**Jacobacci & Partners S.p.A.**
**Piazza della Vittoria 11**
**25122 Brescia (IT)**

(56) References cited:
**WO-A1-2008/112571 WO-A2-2004/079901
ES-A1- 2 341 200**

 • **HARMA A ET AL: "FREQUENCY-WARPED
SIGNAL PROCESSING FOR AUDIO
APPLICATIONS", JOURNAL OF THE AUDIO
ENGINEERING SOCIETY, AUDIO ENGINEERING
SOCIETY, NEW YORK, NY, US, vol. 48, no. 11, 1
November 2000 (2000-11-01), pages 1011 - 1031,
XP001177399, ISSN: 1549-4950**

**Description**

The present invention falls in the field of digital signal processing, in particular for audio signals, and refers in particular to a method and a frequency response adjustment device for a digital filter.

As is known, a digital filtering technique is the FIR filter ("Finite Impulse Response").

In the design of acoustic systems, specifications are described using frequency on a logarithmic scale (similar to the behavior of the human ear). FIR filtering shows significant limitations in terms of computational cost and algorithmic complexity in being able to operate in the low and medium-low frequency band (from 20 to 200 Hz) requiring a very high number of delay taps (on the order of 10,000).

To try to overcome such limitations of FIR filters, a filtering technique based on WFIR filters ("Warped Finite Impulse Response") has been proposed, which allows a non-uniform frequency resolution to be obtained, as instead occurs with classic FIR filtering.

The deformation of the frequency resolution (hence the name Warped) is achieved by replacing the delay element z-1 in the FIR structure with a first-order Allpass filter, as proposed by Strube in "Linear prediction on a warped frequency scale", J. Acoust. Soc. Amer. 68 (4) (1980) 1071-1076.

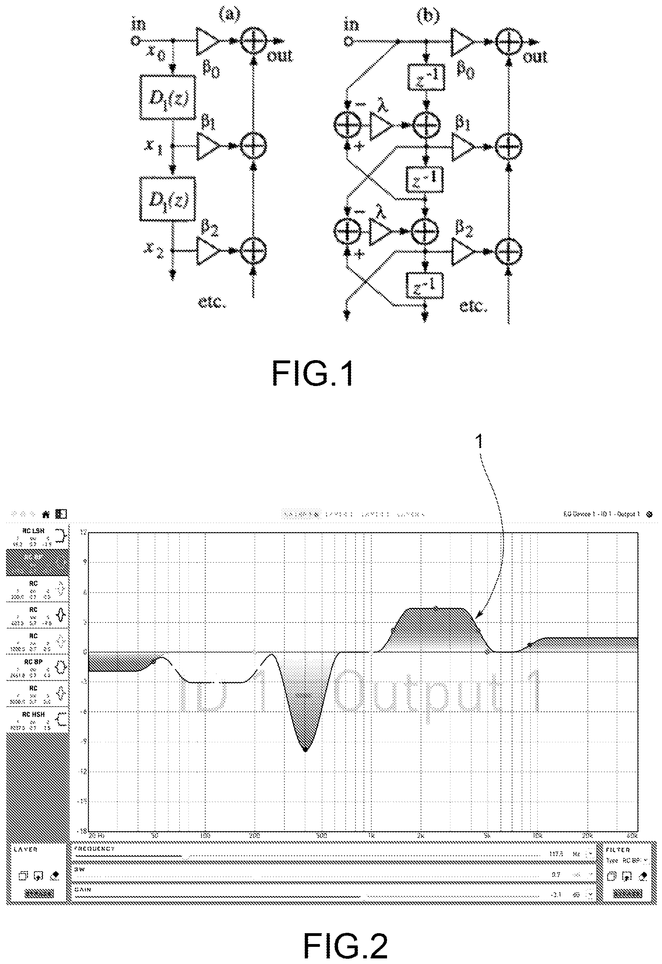

Figure 1 shows a structure of a WFIR filter in direct form I. Figure 1(a) shows an implementation for direct replacement z-1 ⇔ D(z), which, however, also results in an increase in computational cost; Figure 1(b) shows a more efficient structure, for example presented by Matti Karjalainen, Esa Piirilä and Antti Järvinen in "Loudspeaker response equalization using warped digital filters," Proc. NorSig-96, pp. 367-370, Espoo, Finland, September 1996.

Such equivalent structure is able to save memory and operations and makes the overall balance favorable to WFIR, succeeding in achieving simultaneously the aims of precision in low frequency, sustainable computational cost and contained number of delay taps, making it particularly suitable for equalization applications of the audio signal reproduced through acoustic diffusers.

In some audio signal equalization applications, the possibility of processing the audio signals in real-time is required, i.e. to modify, through the use of a user interface, the parameters of the filters, characterizing their frequency response. WO2008/112571 disclosed an audio equalization filter that can be generated by frequency warping one or more digital filters having a plurality of frequency bands.

The object of the present invention is to propose a method and a device to adjust the frequency response of a digital filter able to combine a high quality of filtering with an efficiency and a speed such as to allow an adjustment of the frequency response practically in real time, i.e. limiting as much as possible the delay between the modification of the filter parameters by the user and the result of the modification on the output signal.

Said object is achieved by a method of adjusting the frequency response of a digital filter according to claim 1 and by a digital signal processing device according to claim 11.

The English term "taps" indicates the coefficients, or samples, of a digital filter.

According to claim 1, a method is proposed for adjusting the frequency response of a digital filter by means of a digital signal processing device having a user interface, in particular for the processing of digital audio signals, comprising the steps of:

- defining a desired curve of the frequency response of the filter;
- calculating the taps of the digital filter so as to obtain a frequency response that approaches said desired curve,

    wherein the filter taps are obtained by a the taps of a second WFIR filter, where the taps of the first WFIR filter are calculated through the steps of:

    - starting from the amplitude of the desired curve as a function of the frequency, generating an FIR filter using the window technique, so as to obtain a sequence having a linear phase;
    - applying an inverse Fourier transform to the real part of the logarithm of the Fourier transform module of said linear phase sequence, so as to obtain a minimum phase sequence;
    - applying a WFIR filter with a warping factor $-\lambda$ to said minimum phase sequence;
    - applying a window function to the filtered sequence,

    and wherein the taps of the second WFIR filter are calculated through the steps of:

    - starting from the desired curve, defining a cascade of second-order parametric filters;
    - carrying out a deformation of the frequency axis of said filter cascade, replacing each delay element, z-1, of said filter cascade with a first-order Allpass filter;
    - calculating an FIR filter using an impulse response truncation method for said filter cascade, so as to obtain a finite sequence;

- applying a window function to said finished sequence.

In one embodiment, the step of calculating the taps of the digital filter takes place in real time during the definition of the desired curve and comprises a quick synthesis with a low number of taps during a modification of the desired curve, and a slow synthesis with a large number of taps in the absence of modification of the desired curve.

In one embodiment, a modification of the desired curve during the slow synthesis causes the interruption of the slow synthesis and the switch to the fast synthesis.

In one embodiment, the $\lambda$ parameter of the WFIR filters for the delay lines is variable.

In one embodiment, the states of the Allpass filters are concatenated by means of a pipeline technique so as to obtain a number of taps equal to the sum of the concatenated blocks.

In one embodiment, the processed samples are concatenated so as to subdivide the band to be processed into sub-bands, to each of which a filtering with a different $\lambda$ parameter may be applied, so as to maximize the resolution for the band of interest.

In one embodiment, the cascade of the Allpass filter may be expressed with the formula:

$$Yn = \lambda*(Yn-1 - Xn) + Xn-1.$$

In one embodiment, the FIR filter applied to the state variables of the first-order Allpass filter cascade may be expressed with the formula:

$$Yn = (Xn-1 * tap) + Accumulator$$

wherein

Xn indicates the sample at the input to the second-order nth parametric filter.

Xn-1 indicates the previous sample of the second-order parametric filter, which corresponds to the output sample of the previous filter;

Yn indicates the sample at the output from the second-order nth parametric filter.

Tap represents the tap for the application of the FIR filter.

In one embodiment, the FIR filtering operation on the states is carried out in parallel with the Allpass filtering operation.

Further object of the present invention is a device for processing digital signals, in particular audio signals, comprising hardware and software means suitable for implementing a method for adjusting the frequency response of a digital filter as described above.

In one embodiment, the device comprises:

- a shifting module comprising shift registers for the calculation of parameters with history, such as Xn-1 and Yn-1;
- a storing module comprising random access memory, RAM, for storing the taps modifiable in real time and the states of the cascade and the Allpass filters;
- a processing module for the implementation of filtering functions using Allpass and FIR filters;
- a multiplexing module to implement the feedback of the results of the functions performed by the processing module.

In one embodiment, the device comprises a manager module suitable for managing the inputs and outputs of shifting, storing, processing and multiplexing modules.

The features and advantages of the adjustment method and device according to the invention will, however, become evident from the description provided hereinafter of their preferred embodiments, provided to be indicative and non-limiting, with reference to the accompanying figures, wherein:

- figures 1(a) and 1(b) illustrate a WFIR filtering technique according to two possible known implementations;
- figure 2 is an example of a user interface for setting the frequency response of a digital filter;
- figure 3 is a block diagram of the general algorithm of the adjustment method according to the invention;
- figure 4 is a graphical representation of the effect of the synthesis of frequency responses on individual groups of signals;
- figure 5 is a block diagram of the synthesis step of the taps of the digital filter according to one aspect of the invention;
- figure 6 is a schematic representation of the concatenation of the states of the Allpass filters;
- figure 7 is a schematic representation of the concatenation of the processed samples; and
- figure 8 is a block diagram of the architecture of the adjustment device according to the invention.

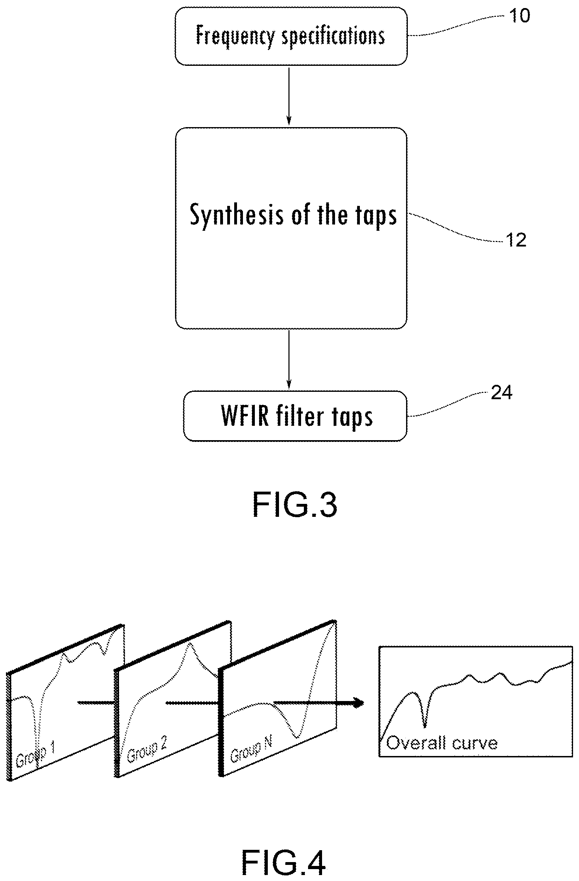

Figure 3 represents the general algorithm for adjusting the frequency response of a digital filter, which comprises a synthesis block 12 of the taps of the filter starting from a set 10 of frequency specifications of a desired curve describing the frequency response of the filter.

Figure 2 shows an example of a graphical user interface for adjusting the frequency response. The user-designed curve that represents the variable trend of the frequency response of the filter as a function of the frequency is indicated with 1.

For example, the curve 1 is defined, for each frequency sub-interval, by one or more parameters that define and characterize the desired curve.

Therefore, the proposed adjustment algorithm must calculate the filter taps, starting from the curve 1, also known as the "target curve", drawn by the operator.

Such operation is defined, with reference to the general algorithm of figure 3, "synthesis of the taps".

The operator has available various tools for defining the target curve 1, from the use of the mouse, to the use of gestures via a touch pad. In another embodiment, parameters may be edited by writing the precise number, or by using sliders.

In one embodiment, each individual channel may be part of a group of signals to which the operator may apply a desired filtering. Thus, the synthesis step 12 of the taps is preceded by the synthesis of the transfer functions of all the channels contributing to the definition of the overall curve.

Figure 4 is a graphic representation of the effect of the synthesis of the transfer functions of each channel belonging to the group represented.

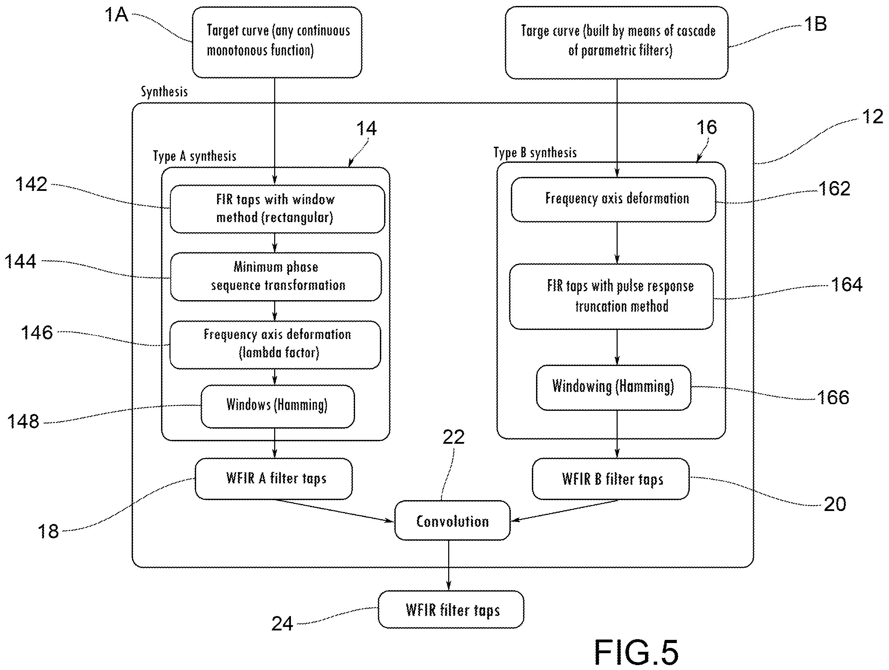

According to one aspect of the invention, the synthesis step 12 of the taps is broken down into two distinct sub-steps 14, 16 (type A synthesis, or first synthesis, and type B synthesis, or second synthesis) having as a result the taps of the overall filter (Figure 5).

The type A synthesis 14 is suitable for generating filters from a target curve 1A which specifies the amplitude of the transfer response of the filter as a function of the frequency.

These frequency specifications are used to generate an FIR using the windows technique (step 142). The filter obtained is a sequence that has the characteristic of having a linear phase.

The sequence is subsequently returned to minimum phase by taking the real part of the cepstrum (step 144).

As is known, the cepstrum is the inverse Fourier transform of the real part of the logarithm of the modulus of the Fourier transform of a sequence, and has the property of having the same modulus, but minimum phase with respect to the starting sequence.

Subsequently (step 146), the sequence obtained is brought into the "warped" domain, through filtering by a WFIR filter with a warping factor $-\lambda$ (note the opposite sign relative to the parameter used in real-time low-level filtering).

A window (e.g. with a Hamming filter) is then applied to the sequence after warping (step 148), in order to have the best compromise between frequency resolution and the containment of the artifacts introduced by the truncation of the virtually infinite sequence to N taps.

The taps 18 of the WFIR A filter are thus obtained.

The type B synthesis 16 starts from a target curve 1B generated by a filter that replicates the effect of a cascade of second-order parametric filters (in technical jargon "biquad"), typical of audio applications.

The deformation of the frequency axis (step 162) occurs by recalculation of the coefficients [a0 a1 a2] and [b0 b1 b2], typical of a second-order filter, in coefficients [aw0 aw1 aw2] and [bw0 bw1 bw2] obtained by replacing the delay element z-1 with a first-order Allpass filter.

Thus, the impulse response of the second-order filter cascade system (step 164) is generated and then truncated to obtain a finite sequence.

Subsequently, such truncated sequence is then windowed, for example by means of a Hamming filter (step 166).

The taps 20 of the WFIR B filter are thus obtained.

The two sequences 18, 20 obtained through the two synthesis procedures A and B are then convoluted (step 22) to obtain the final sequence 24, which will take into account all the specifications of the overall curve.

Note that the design of the frequency response, as well as the synthesis of the taps, must allow for speed and consistency.

"Speed" means that the operator must not feel a slowdown or pause while dragging the mouse or making a gesture.

From analyses performed, a fast command execution time means one that is performed in a maximum time of 5ms.

The speed, however, must not compromise the consistency of the data (what the software shows on the screen must correspond to the processing performed by the device).

Therefore, in one embodiment, the sending of a command consists of two moments:

- Sending the command;

- Receiving the confirmation of its implementation.

The graphics are therefore updated only if the command has been executed correctly.

In this way, the consistency of data between software and processing may be assured.

The synthesis may be carried out by high-level software, as well as directly in the embedded environment.

However, to ensure consistency (the device, when restarted, must be able to perform the same filtering without the need to use high-level software), appropriate measures must be taken in case the synthesis is carried out at a high level.

The situation wherein the connection between software and devices is compromised is also managed.

In this scenario, it may happen that a command sent by the software may not be completed. To support such a scenario, there is device-level thread management, which, at predetermined time intervals, checks the consistency of the data.

The need to obtain a frequency response superimposable to the defined target (i.e. to minimize the error between the target and the result), is satisfied by appropriately calibrating the $\lambda$ parameter and increasing the number of taps.

However, this would be at odds with the speed of synthesis of the taps, the required computational load of which increases in proportion to the number of taps.

The proposed method and adjustment device allow the criteria of speed, consistency and quality to be satisfied simultaneously.

Taking into consideration a database of pulses for different frequency curves, it has been analytically found that the first 32 taps already allow the frequency response to be defined with good approximation.

According to one aspect of the invention, an adaptive synthesis of the taps is used: a quick synthesis with a sufficient number of taps to characterize the frequency response in the transients (for example during movement of the mouse or while making a gesture), with a progressively slower synthesis, but with a greater number of taps, when the operator interrupts his/her intervention.

A new intervention of the operator, during the period of time wherein the high-quality synthesis is carried out, must interrupt the current synthesis in favor of speed.

Such objective is achieved by using a series of threads, one for each processing channel, which, upon receipt of a command, wait a certain time, for example fixed at 1 second, after which they start the qualitative synthesis.

In the event that a new command is received (thus the operator is intervening on the parameters of the filter), if the command is of the same channel for which the qualitative synthesis has been started, the thread is interrupted to favor the execution of the fast command, to then restart the qualitative synthesis procedure.

For example, one may hypothesize a synthesis made in less than 5ms for the fast solution and a synthesis that may reach even 10s in the case of slow synthesis (time needed for the signal to become stable).

As for the practical execution of WFIR filters, in one embodiment, raised cosine filters are used, as well as classic filters (parametric, high pass, low pass, all pass and shelving), using high quality WFIR filters based on an FPGA architecture.

Such technique allows for minimum phase filtering and real-time processing to be obtained.

"Real-time" here means that after receiving samples of different channels, with clocks in the domain of audio signals (now 96kHz), the processed sample, net of a still contained latency (few clock pulses), even a single sample clock pulse, provides output samples of the different channels processed.

Considering a clock processing equal to 96kHz, this means that every 10uS or so (1/96000 seconds) one obtains all the output channels processed relative to the input channels received during the previous sampling.

Also object of the present invention is a modular base block capable of processing 16 simultaneous channels, in a single sample, for 128 taps.

The choice of the parameters described below depends on the resources available at the FPGA level (thus there is a multidimensional modularity, both at the level of audio parameters and at the level of resources).

Such block may arbitrarily use floating-point data (float and double) as well as fixed-point data of different data widths as needed and depending on the resources available on the FPGA.

Moreover, such block does not impose a constant $\lambda$ parameter for the delay lines, thus allowing WizFir (Warped Individual z Fir) filtering techniques to be implemented.

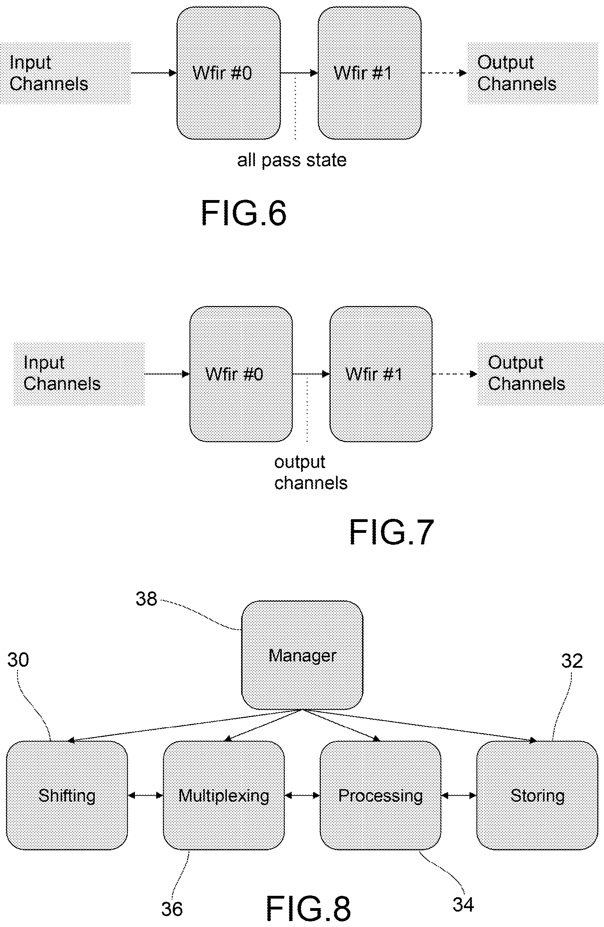

As shown in figures 6 and 7, to achieve high quality, the modular base block may be linked in two ways:

- Concatenation of the states of the Allpass filters (Figure 6); and
- Concatenation of the processed samples (Figure 7).

Concatenation of the states of the Allpass filters allows the number of taps to be increased, resulting in a number of taps equal to the sum of the concatenated blocks; for example, the number of taps is doubled in the case of concatenating two blocks with the same number of taps.

The concatenation of the processed samples allows the band to be processed to be subdivided into sub-bands, to each of which a filtering with a different λ parameter may be applied, so as to maximize the resolution for the band of interest.

According to one aspect of the invention, the modular base block uses multiplication and addition to perform the two main functions at the base of the filtering, namely the first-order Allpass filter and the FIR filter applied to the states of the first-order Allpass filter cascade.

In particular, the formula of the Allpass filter cascade is ascribable to:

$$\mathrm{Yn = \lambda*(Yn\text{-}1 - Xn) + Xn\text{-}1.}$$

The FIR filter, on the other hand, is applied to the state variables of the biquad cascade, i.e.:

$$\mathrm{Yn = (Xn\text{-}1 * tap) + Accumulator,}$$

where

Xn indicates the sample at the input of the n-th biquad;
Xn-1 indicates the previous sample of the biquad, corresponding to the output of the previous biquad;
Yn indicates the output of the n-th biquad;
Tap represents the tap for the application of the FIR filter.

The two operations are set to have a latency time equal to the number of channels to be processed.

For example, the following results were obtained:

- Number of channels to process: 16
- All Pass multiplication latency: 4
- All Pass subtraction latency: 6
- All Pass addition latency: 6
- FIR multiplication latency: 6
- Fir addition latency: 10.

The latency of each single block is calculated taking into account the characteristics of the FPGA, in order to avoid an exorbitant use of resources, as well as to avoid the onset of timing errors.

This allows one to obtain, net of an initial latency time equal to the number of channels to be processed, one processing result for each system clock pulse.

In one embodiment, the FIR filtering operation on the states may be carried out in parallel with the Allpass filtering operation (as it takes the taps and the Xn-1 as input), reducing the overall latency time.

The total latency time is therefore equal to the number of taps, multiplied by the number of channels to be processed, with the addition of a latency time equal to the number of channels to be processed.

Considering, for example, a system clock equal to 200MHz and a sampling equal to 96kHz, 2080 clock pulses are available, i.e.:

Available clock pulses = 200000000/96000 = 2083.3333.

In the hypothesis of 16 processing channels, a processing equal to 128 taps is obtained, insofar:

16 (channels) × 128 (taps) + 16 (initial latency) = 2048 + 16 = 2064.

Note that the processing clock may have jitter and therefore a certain tolerance should be considered, as techniques to handle possible exceptions should be considered.

In an embodiment, for parameters with history, such as parameters Xn-1 and Yn-1, shift registers are used (Shifting module 30 in Figure 8).

In one embodiment, for the storage of the taps, which may be modified in real-time, Block Ram (Storing module 32) is used.

Storing also involves saving the states for the Allpass filter cascade.

A processing module 34 implements the Allpass and FIR filtering functions.

Since the results of the processing functions require feedback, the input of the same processing module passes through multiplexing functions 36 that allow the correct signal to be selected.

In one embodiment, inputs and outputs of the different modules are managed by a Manager module 38, which

**EP 3 763 134 B1**

manages the timing based on selected parameters. The matter for which protection is sought is uniquely defined by the appended set of claims.

**Claims**

1. Method for adjusting the frequency response of a digital filter by means of a digital signal processing device having a user interface, in particular for processing digital audio signals, comprising the steps of:

   - defining a desired curve of the frequency response of the filter;
   - calculating (24) the taps of the digital filter so as to obtain a frequency response that approaches said desired curve,
   wherein the filter taps are obtained by a convolution (22) between the taps of a first WFIR filter (18) and the taps of a second WFIR filter (20), where the taps of the first WFIR filter are calculated through the steps of:

      - starting from the amplitude of the desired curve as a function of the frequency, generating an FIR filter using the window method (142), so as to obtain a sequence having a linear phase;
      - applying an inverse Fourier transform to the real part of the logarithm of the Fourier transform module of said linear phase sequence, so as to obtain a minimum phase sequence (144);
      - applying a WFIR filter with a warping factor -$\lambda$ (146) to said minimum phase sequence;
      - applying a window function (148) to the filtered sequence,

   and wherein the taps of the second WFIR filter are calculated through the steps of:

      - starting from the desired curve, defining a cascade (1B) of second-order parametric filters;
      - carrying out a deformation of the frequency axis (162) of said filter cascade, replacing each delay element, z-1, of said filter cascade with a first-order Allpass filter;
      - calculating an FIR filter using an impulse response truncation method (164) for said filter cascade, so as to obtain a finite sequence;
      - applying a window function (166) to said finite sequence.

2. Method according to claim 1, wherein the step of calculating the digital filter taps takes place in real time during the definition of the desired curve and comprises a quick synthesis with a low number of taps during a modification of the desired curve, and a slow synthesis with a large number of taps in the absence of modification of the desired curve.

3. Method according to the preceding claim, wherein a modification of the desired curve during the slow synthesis causes the interruption of the slow synthesis and the switch to the fast synthesis.

4. Method according to any one of the preceding claims, wherein the WFIR filters are based on an FPGA architecture.

5. Digital signal processing device, in particular audio signal processing device, comprising hardware and software means configured to implement a method for adjusting the frequency response of a digital filter according to any one of the preceding claims.

6. Device according to the preceding claim, comprising:

   - a shifting module (30) comprising shift registers for the calculation of parameters with history, such as Xn-1 and Yn-1;
   - a storing module (32) comprising random access memory RAM, for storing the taps modifiable in real time and the states of the cascade of second order filters and Allpass filters;
   - a processing module (34) for the implementation of filtering functions using Allpass and FIR filters;
   - a multiplexing module (36) to implement the feedback of the results of the functions performed by the processing module.

7. Device according to the preceding claim, comprises a manager module (38) suitable to manage the inputs and outputs of the shifting, storing, processing and multiplexing modules (30, 32, 34, 36).

**Patentansprüche**

1. Verfahren zum Einstellen des Frequenzgangs eines digitalen Filters mittels einer digitalen Signalverarbeitungsvorrichtung, die eine Benutzeroberfläche aufweist, insbesondere zum Verarbeiten digitaler Audiosignale, umfassend die Schritte:

   - Definieren einer gewünschten Kurve des Frequenzgangs des Filters;
   - Berechnen (24) der Abgriffe des digitalen Filters, um einen Frequenzgang zu erhalten, welcher der gewünschten Kurve nahekommt,
   wobei die Filterabgriffe durch eine Faltung (22) zwischen den Abgriffen eines ersten WFIR-Filters (18) und den Abgriffen eines zweiten WFIR-Filters (20) erhalten werden, wo die Abgriffe des ersten WFIR-Filters durch die Schritte berechnet werden:

   - Ausgehend von der Amplitude der gewünschten Kurve als eine Funktion der Frequenz, Generieren eines FIR-Filters unter Verwendung der Fenstermethode (142), um eine Sequenz zu erhalten, die eine lineare Phase aufweist;
   - Anwenden einer inversen Fourier-Transformation auf den Realteil des Logarithmus des Fourier-Transformationsmoduls der linearen Phasensequenz, um eine minimale Phasensequenz (144) zu erhalten;
   - Anwenden eines WFIR-Filters mit einem Warping-Faktor -$\lambda$ (146) auf die minimale Phasensequenz;
   - Anwenden einer Fensterfunktion (148) auf die gefilterte Sequenz,

   und wobei die Abgriffe des zweiten WFIR-Filters durch die Schritte berechnet werden:

   - Ausgehend von der gewünschten Kurve, wobei eine Kaskade (1B) von parametrischen Filtern zweiter Ordnung definiert wird;
   - Durchführen einer Deformation der Frequenzachse (162) der Filterkaskade, wobei jedes Verzögerungselement, z-1, der Filterkaskade durch ein Allpassfilter erster Ordnung ersetzt wird;
   - Berechnen eines FIR-Filters unter Verwendung eines Impulsantwort-Trunkierungsverfahrens (164) für die Filterkaskade, um eine endliche Sequenz zu erhalten;
   - Anwenden einer Fensterfunktion (166) auf die endliche Sequenz.

2. Verfahren nach Anspruch 1, wobei der Schritt des Berechnens der digitalen Filterabgriffe in Echtzeit während der Definition der gewünschten Kurve erfolgt und eine schnelle Synthese mit einer geringen Anzahl von Abgriffen während einer Modifikation der gewünschten Kurve und eine langsame Synthese mit einer hohen Anzahl von Abgriffen ohne Modifikation der gewünschten Kurve umfasst.

3. Verfahren nach dem vorhergehenden Anspruch, wobei eine Modifikation der gewünschten Kurve während der langsamen Synthese die Unterbrechung der langsamen Synthese und das Umschalten auf die schnelle Synthese bewirkt.

4. Verfahren nach einem der vorhergehenden Ansprüche, wobei die WFIR-Filter auf einer FPGA-Architektur basieren.

5. Digitale Signalverarbeitungsvorrichtung, insbesondere Audiosignalverarbeitungsvorrichtung, umfassend Hardware- und Softwaremittel, die zum Implementieren eines Verfahrens zum Einstellen des Frequenzgangs eines digitalen Filters nach einem der vorhergehenden Ansprüche konfiguriert sind.

6. Vorrichtung nach dem vorhergehenden Anspruch, umfassend:

   - ein Schiebemodul (30) mit Schieberegistern zur Berechnung von Parametern mit Historie bzw. Verlauf, wie Xn-1 und Yn-1;
   - ein Speichermodul (32) umfassend RAM-Speicher zum Speichern der in Echtzeit modifizierbaren Abgriffe und der Zustände der Kaskade aus Filtern zweiter Ordnung und Allpassfiltern;
   - ein Verarbeitungsmodul (34) für die Implementierung von Filterfunktionen unter Verwendung von Allpass- und FIR-Filtern;
   - ein Multiplexingmodul (36) zum Implementieren der Rückmeldung der Ergebnisse der von dem Verarbeitungsmodul durchgeführten Funktionen.

7. Vorrichtung nach dem vorhergehenden Anspruch, umfassend ein Manager- bzw. Verwaltungsmodul (38), das geeignet ist, die Eingänge bzw. Eingaben und Ausgänge bzw. Ausgaben der Schiebe-, Speicher-, Verarbeitungs- und Multiplexingmodule (30, 32, 34, 36) zu managen bzw. zu verwalten.

**Revendications**

1. Procédé de réglage de la réponse en fréquence d'un filtre numérique au moyen d'un dispositif de traitement de signaux numériques ayant une interface utilisateur, en particulier pour le traitement de signaux audio numériques, comprenant les étapes suivantes :

   - la définition d'une courbe souhaitée de la réponse en fréquence du filtre ;
   - le calcul (24) des prises du filtre numérique de façon à obtenir une réponse en fréquence qui se rapproche de ladite courbe souhaitée,

   dans lequel les prises de filtre sont obtenues par une convolution (22) entre les prises d'un premier filtre WFIR (18) et les prises d'un deuxième filtre WFIR (20), les prises du premier filtre WFIR étant calculées par le biais des étapes suivantes :

   - en partant de l'amplitude de la courbe souhaitée en fonction de la fréquence, la génération d'un filtre FIR à l'aide du procédé de fenêtrage (142), de façon à obtenir une séquence ayant une phase linéaire ;
   - l'application d'une transformée de Fourier inverse à la partie réelle du logarithme du module de transformée de Fourier de ladite séquence de phase linéaire, de façon à obtenir une séquence de phase minimale (144) ;
   - l'application d'un filtre WFIR avec un facteur de gauchissement - $\lambda$ (146) à ladite séquence de phase minimale ;
   - l'application d'une fonction de fenêtrage (148) à la séquence filtrée, et dans lequel les prises du deuxième filtre WFIR sont calculées par le biais des étapes suivantes :

      - en partant de la courbe souhaitée, la définition d'une cascade (1B) de filtres paramétriques de deuxième ordre ;
      - l'exécution d'une déformation de l'axe de fréquence (162) de ladite cascade de filtres, en remplaçant chaque élément à retard, z-1, de ladite cascade de filtres par un filtre passe-tout de premier ordre ;
      - le calcul d'un filtre FIR à l'aide d'un procédé de troncature de réponse impulsionnelle (164) pour ladite cascade de filtres, de façon à obtenir une séquence finie ;
      - l'application d'une fonction de fenêtrage (166) à ladite séquence finie.

2. Procédé selon la revendication 1, dans lequel l'étape de calcul des prises de filtre numérique se déroule en temps réel lors de la définition de la courbe souhaitée et comprend une synthèse rapide avec un faible nombre de prises lors d'une modification de la courbe souhaitée, et une synthèse lente avec un grand nombre de prises en l'absence de modification de la courbe souhaitée.

3. Procédé selon la revendication précédente, dans lequel une modification de la courbe souhaitée lors de la synthèse lente provoque l'interruption de la synthèse lente et le passage à la synthèse rapide.

4. Procédé selon l'une quelconque des revendications précédentes, dans lequel les filtres WFIR sont basés sur une architecture FPGA.

5. Dispositif de traitement de signaux numériques, en particulier dispositif de traitement de signaux audio, comprenant des moyens matériels et logiciels configurés pour mettre en œuvre un procédé de réglage de la réponse en fréquence d'un filtre numérique selon l'une quelconque des revendications précédentes.

6. Dispositif selon la revendication précédente, comprenant :

   - un module de décalage (30) comprenant des registres à décalage pour le calcul de paramètres avec historique, tels que Xn-1 et Yn-1 ;
   - un module de stockage (32) comprenant une mémoire vive RAM, pour stocker les prises modifiables en temps réel et les états de la cascade de filtres de deuxième ordre et des filtres passe-tout ;
   - un module de traitement (34) pour la mise en œuvre de fonctions de filtrage utilisant des filtres passe-tout et FIR ;
   - un module de multiplexage (36) pour mettre en œuvre la rétroaction des résultats des fonctions réalisées par le module de traitement.

7. Dispositif selon la revendication précédente, comprenant un module de gestion (38) apte à gérer les entrées et sorties des modules de décalage, de stockage, de traitement et de multiplexage (30, 32, 34, 36).

FIG.1

FIG.2

**FIG.3**

**FIG.4**

FIG.5

FIG.6

FIG.7

FIG.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008112571 A

**Non-patent literature cited in the description**

- **STRUBE**. Linear prediction on a warped frequency scale. *J. Acoust. Soc. Amer.*, 1980, vol. 68 (4), 1071-1076

- **MATTI KARJALAINEN** ; **ESA PIIRILÄ** ; **ANTTI JÄRVINEN**. Loudspeaker response equalization using warped digital filters. *Proc. NorSig-96*, September 1996, 367-370